Europäisches Patentamt

European Patent Office

Office européen des brevets

(11) Publication number: **0 079 922**
**B1**

# (12) EUROPEAN PATENT SPECIFICATION

(45) Date of publication of patent specification: **11.11.87**

(51) Int. Cl.⁴: **H 04 B 1/04**

(21) Application number: **82901690.6**

(22) Date of filing: **19.04.82**

(86) International application number:
**PCT/US82/00499**

(87) International publication number:
**WO 82/04365 09.12.82 Gazette 82/29**

(54) **RADIO TRANSMITTER MODULATION CONTROL CIRCUITRY.**

(30) Priority: **26.05.81 US 267096**

(43) Date of publication of application:
**01.06.83 Bulletin 83/22**

(45) Publication of the grant of the patent:
**11.11.87 Bulletin 87/46**

(84) Designated Contracting States:
**AT DE FR NL SE**

(56) References cited:
**US-A-2 025 595**
**US-A-3 643 173**
**US-A-3 796 971**
**US-A-4 117 412**
**US-A-4 122 417**
**US-A-4 187 479**
**US-A-4 189 681**
**US-A-4 225 822**

**ELECTRONICS, vol. 49, no. 7, April 1, 1976,
pages 82,83, New York, US; B. GILBERT:
"Nonlinear low-pass filter rejects impulse
signals"**

(73) Proprietor: **MOTOROLA, INC.**
**1303 East Algonquin Road**
**Schaumburg, Illinois 60196 (US)**

(72) Inventor: **WEBER, Paul John**
**979 Oakdale Drive**
**Elgin, IL 60120 (US)**

(74) Representative: **Ibbotson, Harold**
**Motorola Ltd Patent and Licensing Operations -**
**Europe Jays Close Viables Industrial Estate**
**Basingstoke Hampshire RG22 4PD (GB)**

Courier Press, Leamington Spa, England.

## Description

Background of the invention

The present invention relates generally to radio frequency (RF) signal transmitters, and more particularly to circuitry for controlling the modulation of such RF signal transmitters.

In both frequency and amplitude modulated RF signal transmitters, it is necessary to limit the degree of modulation of the transmitter due to Federal Communications Commission (FCC) requirements. Furthermore, overmodulating of the transmitter may also result in modulating signal distortion and interference with other radio communications. Conventional circuitry for limiting transmitter modulation have typically utilized back-to-back rectifiers or diodes, as shown in U.S. Patent Nos. 2,025,595, and 2,491,590, and have also utilized limiting circuitry such as that described in U.S. Patent Nos. 3,320,536, 3,626,331, 3,986,049 and 4,038,603, for preventing the modulating signals from exceeding a predetermined maximum peak-to-peak voltage swing. However, these circuits are non-linear in nature transforming the modulating signals into square waves. The harmonic signal content of the square waves causes the transmitted signal to have a wider than normal bandwidth. In order to keep the bandwidth of the transmitted signal within preselected limits, a so-called splatter filter is typically introduced between the modulation control circuitry and the transmitter. A splatter filter sharply attenuates signals having frqeuencies above 3000 Hz. However, since such splatter filters do not adequately attenuate all of the harmonic signals in the square waves, the modulating signals must be further attenuated in amplitude before application to the modulator so that the FCC modulation limit of the transmitted signal is not exceeded. Furthermore, reducing the modulating signal amplitude degrades audio signal quality since the signal-to-noise ratio is decreased.

In US Patent No. 4 225 822 there is disclosed a circuit for controlling modulation of a radiofrqeuency transmitter by audio signals from a signal source comprising audio signal amplifying means coupled to the signal source, modulating means and a transmitter. The audio amplifier comprises input impedance means connected between the signal source and an amplifier and a feedback path including a filter circuit and other impedance circuits. The output of the amplifier is connected to the modulator and to the filter which eliminates unwanted components.

Summary of the invention

Accordingly, it is an object of the present invention to provide improved transmitter modulation control circuitry that substantially maximizes the signal-to-noise ratio of the transmitted signal.

It is another object of the present invention to provide improved transmitter modulation control circuitry that alters the phase of high frequency harmonic signals produced by amplitude limiting of the modulating signals.

Accordingly, the invention provides modulation control circuitry for controlling modulation of a radio frequency signal transmitter by audio signals from a signal source, said modulation control circuitry including an audio signal amplifier coupled to the signal source and a modulator coupled between the audio signal amplifier and the transmitter, said modulation control circuitry further comprising:

input imepdance means having first and second terminals, the first terminal of the input impedance means being coupled to the audio signals from the signal source;

amplifying means, having two input terminals and an output terminal, for amplifying a signal at its input terminals to provide an amplified signal at its output terminal, one of the input terminals of the amplifying means being coupled to the second terminal of the input impedance means;

feedback impedance means having first and second terminals, the first terminal of the feedback impedance means coupled to the modulator, and the second terminal of the feedback impedance means being coupled to one of the input terminals of the amplifying means; and said modulation control circuitry further comprising

filtering means, having input and output terminals, for filtering a signal at its input terminal to provide a filtered signal at its output terminal, the input terminal of the filtering means being coupled to the output terminal of the amplifying means and the output terminal of the filtering means coupled to the first terminal of the feedback impedance means and the modulator.

The output signal from the audio signal amplifier may be coupled to a splatter filter and thereafter to a modulator for modulating a radio signal transmitter. Once the modulation limit of the transmitted signal has been selected, the amplitude of the output signal from the splatter filter can be adjusted so that the modulation limit is not exceeded when the audio signal amplifier is driven into amplitude limiting. By utilizing the improved audio signal amplifier of the present invention, the average power of the modulating signal can be greatly increased over that achievable by the prior art, resulting in a significant improvement in signal-to-noise ratio.

Brief description of the drawings

Fig. 1 is a block diagram of transmitter modulation control circuitry embodying the present invention.

Fig. 2 is a typical waveform illustrating the signal generated by audio amplifier 120 in Fig. 1 when audio amplifier is driven into amplitude limiting.

**0 079 922**

Fig. 3 is a typical waveform illustrating the signal generated by splatter filter 130 in Fig. 1 in response to the audio amplifier signal illustrated in Fig. 2.

Fig. 4 is a typical waveform illustrating the signal generated by splatter filter 130 in Fig. 1 in response to a square wave.

Description of the preferred embodiment

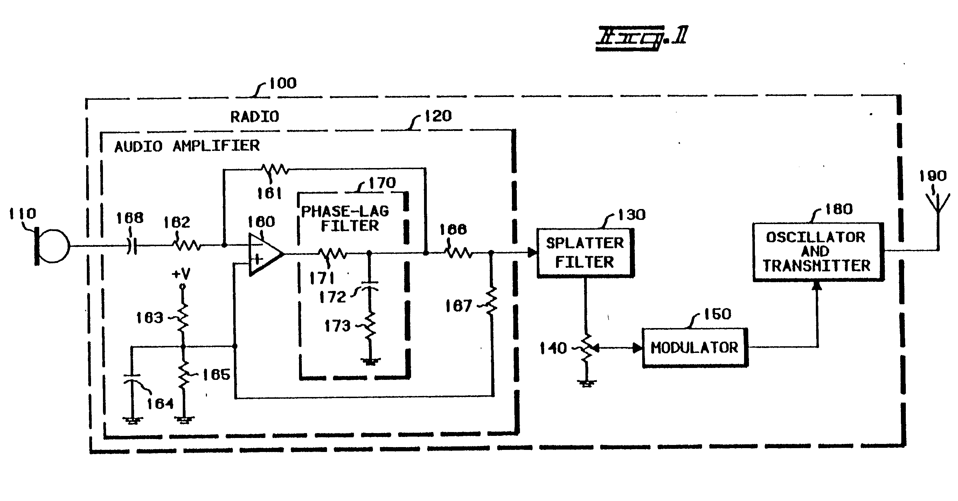

In Fig. 1, there is illustrated a radio 100 embodying the transmitter modulation control circuitry of the present invention. The transmitter modulation control circuitry includes microphone 110, audio amplifier 120, splatter filter 130, modulator 150, osicllator and transmitter 180 and antenna 190. Microphone 110, splatter filter 130, modulator 150 and oscillator and transmitter 180 are conventional circuit elements found in frequency modulated (FM) radios, such as, for example, the FM radio described in Motorola Instruction Manual 68P81043E45, entitled "Syntor Two-Way FM Radio", published by Motorola Service Publications, 1301 East Algonquin Road, Schaumburg, Illinois, 1980. Conventional frequency modulation techniques are described in detail in "Information Transmission, Modulation, and Noise", by Mischa Schwartz, published by McGraw-Hill Book Co., Inc., 1959, at pages 111—141.

Audio signals from microphone 110 are coupled to audio amplifier 120 which provides a preselected amount of gain to the audio signals. Audio amplifier 120 has a flat frqeuency response over the audio signal frequency range, typically 300 Hz to 3000 Hz for radio communications. The amplified audio signals from audio amplifier 120 are coupled to splatter filter 130 which attenuates high frequency signals. Splatter filter 130 is typically a low pass filter that sharply attenuates signals having a frequency greater than 3000 Hz. High frequency signals must be attenuated by the splatter filter 130 since such high frequency signals would otherwise cause the transmitted signal to exceed bandwidth limits set by the Federal Communications Commission (FCC).

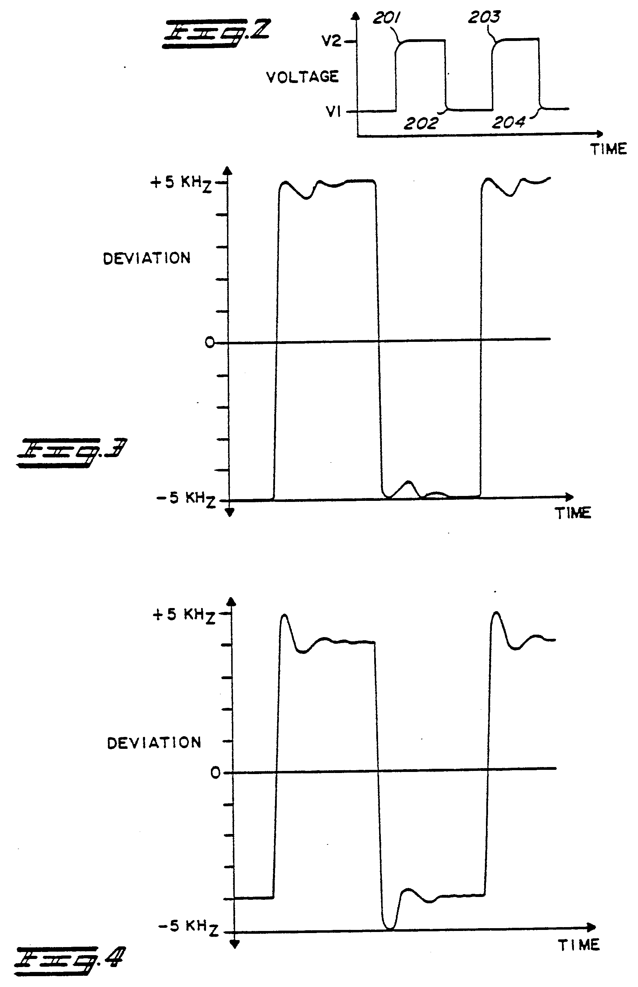

The audio signals from splatter filter 130 are coupled to potentiometer 140 and thereafter to modulator 150. Potentiometer 140 is included for adjusting the modulation of the transmitted signal. In order to set the modulation of the transmitted signal to the FCC modulation limit, a 1,000 Hz signal is typically introduced into audio amplifier 120 at a sufficient amplitude to drive audio amplifier 120 into amplitude limiting, as illustrated by the waveform in Fig. 2. While audio amplifier 120 is being driven into amplitude limiting, potentiometer 140 is adjusted so that peaks of the transmitted signal do not exceed the FCC modulation limit. For example, the FM radio described in aforementioned Motorola manual No. 68P81043E45 has a 5000 Hz modulation limit, commonly referred to as the maximum allowable transmitter deviation.

In the preferred embodiment of the present invention, audio amplifier 120 includes a conventional operational amplifier 160 and a phase-lag filter 170 coupled between the operational amplifier output and feedback resistor 161. Audio signals from microphone 110 are coupled to operational amplifier 160 by way of capacitor 168 and input resistor 162. The voltage gain provided by operational amplifier 160 is determined approximately by the ratio of the feedback resistor 161 to the input resistor 162. Operational amplifier 160 is biased at one-half of the +V supply voltage by resistor divider 163 and 165. If both positive and negative supply voltages are available, resistors 163 and 165 and capacitor 164 are not needed since the plus input of operational amplifier 160 and resistor 167 may be connected directly to signal ground. The biasing voltage from resistors 163 and 165 is filtered by capacitor 164 and also applied to output resistor 166 via resistor 167. Output resistor 166 and resistor 167 comprise a voltage divider which reduces the maximum peak-to-peak output signal from audio amplifier 120 to an acceptable level for splatter filter 130. The electrical characteristics of amplifying circuits using operational amplifiers are generally described in "Analog Computer Techniques", by Clarence L. Johnson, published by McGraw-Hill Book Company, Inc., 1963.

According to an important feature of the present invention, phase-lag filter 170 consisting of resistors 171 and 173 and capacitor 172, is introduced inside the feedback loop of operational amplifier 160. The phase-lag filter 170 has no effect on the amplifier output signal until the operational amplifier 160 is driven into amplitude limiting. Thus, when operational amplifier 160 is not being driven into amplitude limiting, the effects of phase-lag filter 170 are eliminated since phase-lag filter 170 is included in the feedback loop with resistor 161. When driven into amplitude limiting, the clipped amplifier output signal is no longer affected by the feedback loop and instead is affected by the phase-lag filter 170. The phase-lag filter 170 alters both the amplitude and phase of the harmonic signals so that the rising and falling edges 201—204 of the clipped amplifier output signal are rounded off, as illustrated by the waveform in Fig. 2. As illustrated in Fig. 3, the output signal of splatter filter 130 does not overshoot its peak-to-peak voltage in response to the waveform illustrated in Fig. 2, whereas, as illustrated in Fig. 4, the output signal of splatter filter 130 overshoots its peak-to-peak voltage in response to a square wave. Potentiometer 140 must be adjusted to take into account the overshoot of the splatter filter output signal in Fig. 4, introducing more attenuation than required for the splatter filter output signal in Fig. 3. Since the splatter filter output signal in Fig. 3 does not overshoot, the average modulating signal power is increased over that obtainable by prior art modulating circuitry. Based on empirical measurements, transmitter modulation control circuitry embodying the present invention results in a 2.1 dB improvement or a 64% increase in average modulating signal power when utilized in an FM radio having a maximum deviation of 5,000 Hz.

The particular values of the components 171, 172 and 173 in phase-lag filter 170 will depend on the electrical characteristics of the splatter filter 130 actually utilized. For an FM radio having a +V voltage

3

supply of 13.6 volts, approximate component values for the circuit elements of audio amplifier 120 are shown in Table I hereinbelow. An audio amplifier mechanized with these components has a small signal gain of approximately twelve.

TABLE I

| | |
|---|---|
| Operational Amplifier 160 | MC3403 |
| Resistor 161 | 720,000 ohms |
| Resistor 162 | 62,000 ohms |
| Resistor 163 | 10,000 ohms |
| Capacitor 164 | 10 microFarads |
| Resistor 165 | 10,000 ohms |
| Resistor 166 | 470,000 ohms |
| Resistor 167 | 470,000 ohms |
| Resistor 171 | 27,000 ohms |
| Capacitor 172 | 1,800 PicoFarads |
| Resistor 173 | 62,000 ohms |

In summary, an improved radio transmitter modulation control circuitry has been described that significantly increases the average power of the transmitter modulating signal. The transmitter modulation control circuitry can be utilized in both amplitude and frequency modulated radios for enhancing the audio signal performance thereof. Since the signal-to-noise radio of the modulating signal is increased by utilizing the present invention, the intelligibility of radio communications is greatly improved.

## Claims

1. Modulation control circuitry for controlling modulation of a radio frequency signal transmitter (180) by audio signals from a signal source (110), said modulation control circuitry including an audio signal amplifier (120) coupled to the signal source (110) and a modulator (150) coupled between the audio signal amplifier (120) and the transmitter (180), said modulation control circuitry further comprising:

input impedance means (162, 168) having first and second terminals, the first terminal of the input impedance means being coupled to the audio signals from the signal source (110);

amplifying means (160), having two input terminals and an output terminal, for amplifying a signal at its input terminals to provide an amplifier signal at its output terminal, one of the input terminals of the amplifying means (160) being coupled to the second terminal of the input impedance means (162, 168);

feedback impedance means (161) having first and second terminals, the first terminal of the feedback impedance means (161) coupled to the modulator (150), and the second terminal of the feedback impedance means (161) being coupled to one of the input terminals of the amplifying means (160); and said modulation control circuitry further characterized by

filtering means (170), having input and output terminals, for filtering a signal at its input terminal to provide a filtered signal at its output terminal, the input terminal of the filtering means (170) being coupled to the output terminal of the amplifying means (160) and the output terminal of the filtering means (170) coupled to the first terminal of the feedback impedance means (161) and the modulator (150).

2. The modulation control circuitry according to Claim 1, further characterized by attenuating means (140) having an input terminal coupled to the output terminal of the filtering means (170) and an output terminal coupled to the modulator (15), for attenuating the filtered signal from the filtering means (170).

3. The modulation control circuitry according to Claim 2, characterized in that the amplifying means (160) comprises an operational amplifier.

4. The modulation control circuitry according to Claim 1 or 3, characterized in that the filtering means (170) includes phase shifting circuitry (171, 172, 173) for phase shifting and attenuating the signals from the amplifying means (160).

5. The modulation control circuitry according to Claim 4, characterized in that the phase shifting circuitry (171, 172, 173) includes a capacitive impedance (172) and a resistive impedance (171, 173).

6. The modulation control circuitry according to Claim 1 or 3, characterized for use in a radio (100) having a frequency-modulated transmitter.

7. The modulation control circuitry according to Claim 1 or 3, characterized for use in a radio (100) having an amplitude-modulated transmitter.

## Patentansprüche

1. Modulations-Steuerschaltung zur Steuerung der Modulation eines Hochfrequenzsignalsenders (160) durch Audiosignale von einer Signalquelle (110), wobei die Modulations-Steuerschaltung einen mit der Signalquelle (110) verbundenen Audiosignalverstärker (120) und einen Modulator (150) enthält, der zwischen den Audiosignalverstärker (120) und den Sender (180) geschaltet ist, wobei die Modulations-Steuerschaltung weiterhin enthält:

eine Eingangs-Impedanzeinrichtung (162, 168) mit ersten und zweiten Anschlüssen, wobei der erste

**0 079 922**

Anschluß der Eingangs-Impedanzeinrichtung mit den Audiosignalen von der Signalquelle (110) verbunden ist;

eine Verstärkungseinrichtung (160) mit zwei Eingangsanschlüssen und einem Ausgangsanschluß zum Verstärken eines Signals an seinen Eingangsanschlüssen zur Erzeugung eines verstärkten Signals an seinem Ausgangs-Anschluß, wobei einer der Eingangsanschlüsse der Verstärkungseinrichtung (160) mit dem zweiten Anschluß der Eingangs-Impedanzeinrichtung (162, 168) verbunden ist;

eine Rückkopplungs-Impedanzeinrichtung (161) mit ersten und zweiten Anschlüssen, wobei der erste Anschluß der Rückkopplungs-Impedanzeinrichtung (161) mit dem Modulator (150) verbunden ist und der zweite Anschluß der Rückkopplungs-Impedanzeinrichtung (161) mit dem einen der Eingangsanschlüsse der Verstärkungseinrichtung (160) verbunden ist, und wobei die Modulations-Steuerschaltung weiterhin gekennzeichnet ist durch:

eine Filtereinrichtung (170) mit Eingangs- und Ausgangsanschlüssen zum Filtern eines Signals an seinem Eingangsanschluß, um ein gefiltertes Signal an seinem Ausgangsanschluß zur Verfügung zu stellen, wobei der Eingangsanschluß der Filtereinrichtung (170) mit dem Ausgangsanschluß der Verstärkungseinrichtung (160) verbunden ist und der Ausgangsanschluß der Filtereinrichtung mit dem ersten Anschluß der Rückkopplungs-Impedanzeinrichtung (160) und dem Modulator (150) verbunden ist.

2. Modulations-Steuerschaltung nach Anspruch 1, weiterhin gekennzeichnet durch eine Dämpfungseinrichtung (140), die einen mit dem Ausgangsanschluß der Filtereinrichtung (170) verbundenen Eingangsanschluß und einen mit dem Modulator (150) verbundenen Ausgangsanschluß aufweist, um das gefilterte Siganl von der Filtereinrichtung (170) zu dämpfen.

3. Modulations-Steuerschaltung nach Anspruch 2, dadurch gekennzeichnet, daß die Verstärkungseinrichtung (160) einen Operationsverstärker enthält.

4. Modulations-Steuerschaltung nach Anspruch 1 oder 3, dadurch gekennzeichnet, daß die Filtereinrichtung (170) eine Phasenschieberschaltung (171, 172, 173) zur Phasenverschiebung und Dämpfung der Signale von der Verstärkungseinrichtung (160) enthält.

5. Modulations-Steuerschaltung nach Anspruch 4, dadurch gekennzeichnet, daß die Phasenschieberschaltung (171, 172, 173) eine kapazitive Impedanz (172) und eine ohmsche Impedanz (171, 173) enthält.

6. Modulations-Steuerschaltung nach Anspruch 1 oder 3, gekennzeichnet zur Verwendung in einem Funkgerät (100), das einen frequenzmodulierten Sender hat.

7. Modulations-Steuerschaltung nach Anspruch 1 oder 3, gekennzeichnet zur Verwendung in einem Funkgerät (100), das einen amplitudenmodulierten Sender hat.

**Revendications**

1. Circuit de commande de modulation destiné à commander la modulation d'un émetteru de signaux en radiofréquences (180) par des signaux de son provenant d'une source de signaux (110), ledit circuit de commande de modulation comportant un amplificateur de signaux de son (120) couplé avec la source de signaux (110), et un modulateur (150) couplé entre l'amplificateur de signaux de son (120) et l'émetteur (180), ledit circuit de commande de modulation comportant en outre:

une impédance d'entrée (162, 168) avec une première et une seconde borne, la première borne de l'impédance d'entrée étant couplée avec les signaux de son provenant de la source de signaux (110),

un amplificateur (160) avec deux bornes d'entrée et une borne de sortie pour amplifier un signal à ses bornes d'entrée et produire un signal amplifié à sa borne de sortie, l'une des bornes d'entrée de l'amplificateur (160) étant couplée avec la seconde borne de l'impédance d'entrée (162, 168),

une impédance de réaction (161) avec une première et une seconde borne, la première borne de l'impédance de réaction (161) étant couplée avec le modulateur (150) et la seconde borne de l'impédance de réaction (161) étant couplée avec l'une des bornes d'entrée de l'amplificateur (160), ce circuit de commande de modulation étant en outre caractérisé par:

un circuit de filtrage (170) avec des bornes d'entrée et de sortie pour filtrer un signal à sa borne d'entrée et produire un signal filtré à sa borne de sortie, la borne d'entrée du circuit de filtrage (170) étant couplée avec la borne de sortie de l'amplificateur (160) et la borne de sortie du circuit de filtrage (170) étant couplée avec la première borne de l'impédance de réaction (161) et le modulateur (150).

2. Circuit de commande de modulation selon la revendication 1, caractérisé en outre par un circuit atténuateur (140) ayant une borne d'entrée reliée à la borne de sortie du circuit de filtrage (170) et une borne de sortie reliée au modulateur (15) pour atténuer le signal filtré provenant du circuit de filtrage (170).

3. Circuit de commande de modulation selon la revendication 2, caractérisé en ce que l'amplificateur (160) consiste en un amplificateur opérationnel.

4. Circuit de commande de modulation selon la revendication 1 ou 3, caractérisé en ce que le circuit de filtrage (170) comporte un circuit de déphasage (171, 172, 173) pour déphaser et atténuer les signaux provenant de l'amplificateur (160).

5. Circuit de commande de modulation selon la revendication 4, caractérisé en ce que le circuit déphaseur (171, 172, 173) comporte une impédance capacitive (172) et une impédance résistive (171, 173).

6. Circuit de commande de modulation selon la revendication 1 ou 3, caractérisé en ce qu'il est utilisé dans un appareil radioélectrique (100) comprenant un émetteur modulé en fréquences.

7. Circuit de commande de modulation selon la revendication 1 ou 3, caractérisé en ce qu'il est utilisé dans un appareil radioélectrique (100) comprenant un émetteur modulé en amplitude.

Fig.1

# 0 079 922

Fig.2

VOLTAGE

V2

V1

201  203

202  204

TIME

Fig.3

DEVIATION

+5 KHz

0

-5 KHz

TIME

Fig.4

DEVIATION

+5 KHz

0

-5 KHz

TIME